# EUROPEAN PATENT APPLICATION

(11) **EP 2 397 899 A1**
(43) Date of publication of application: **21.12.2011**
(21) Application number: 10166022.3
(22) Date of filing: 15.06.2010
(51) Int. Cl.: G03F 1/00, H01L 51/00, C23C 14/04, G03F 7/20

(54) **Mask holding device**

(71) Applicant: Applied Materials, Inc., Santa Clara, CA 95054 (US)
(72) Inventor: Bangert, Stefan, 36396, Steinau (DE); Landgraf, Heike, 63486, Bruchköbel (DE); Schuessler, Uwe, 63743, Aschaffenburg (DE)
(74) Representative: Zimmermann & Partner

(57) **Abstract**

A holding device (100) adapted for holding a mask (201) and a substrate (101) during processing of the substrate (101) is provided. The holding device (100) includes a mask frame (203) adapted for supporting the mask (202) and a substrate carrier (102) adapted for carrying the substrate (101) to be processed. The substrate carrier (102) has at least one recess (103) adapted for receiving the mask frame (203) which holds the mask (202).

## Description

### TECHNICAL FIELD OF THE INVENTION

Embodiments of the present invention relate to a holding device for a mask, and in particular to a holding device for holding a mask and a substrate during processing of the substrate. The holding device may be used for producing alternative energy products such as solar cells, light-emitting diodes or organic light-emitting diodes. Furthermore, the present invention relates to a method for holding a mask during substrate processing.

### BACKGROUND OF THE INVENTION

A variety of microelectronic, microtechnique, microoptic or combined devices are based on substrates which are processed in an appropriate manner. For example, substrates may be processed for forming photovoltaic layers, light emitting layers, or for modifying surfaces etc. In many cases, substrates are coated by thin films which are structured during a deposition process. Such kind of patterning is based on a mask arranged at a surface of a substrate to be processed. Masking a substrate may be performed by using a mask foil attached to a mask frame. As integrated circuits and other structures are rapidly shrinking in feature size, micro-patterning techniques may be applied to achieve a desired minimum line width of the pattern. Patterns may be formed closely adjacent to each other on a substrate to be processed. An increasing level of complexity of device and integration of devices formed by micro-technological methods may be achieved by a processing technology based on a fine pattern of a mask device. This pattern typically is formed with a high accuracy which increases the cost of the mask device.

During patterning the substrate to be processed the mask is arranged between a deposition source providing the deposition material and the substrate. In particular, the mask is closely attached to a substrate surface to be processed. The mask device may include a mask foil and a mask frame holding the mask foil. The mask foil may include a desired pattern which is transferred, during a deposition process, onto the substrate surface. When the deposition source emits deposition material towards the surface of the substrate, the pattern of the mask foil at least partially shields the surface of the substrate to be processed from deposition material. Thus, a desired pattern may be obtained at the surface of the substrate.

In order to obtain an efficient coverage of the substrate surface to be processed by deposition material, shadowing effects of the mask frame holding the mask foil should be avoided. A cost-effective mask holding a device permitting a reuse of the mask device in subsequent processing steps such that a good material utilization is achieved, is an issue.

### SUMMARY OF THE INVENTION

In light of the above, a holding device adapted for holding a mask and a substrate during processing in accordance with independent claim 1 is provided. Furthermore, a method for processing a substrate using a mask device in accordance with independent claim 10 is provided.

According to one embodiment, a holding device adapted for holding a mask and a substrate during processing is provided, the holding device including a mask frame adapted for supporting the mask; and a substrate carrier adapted for carrying the substrate, wherein the substrate carrier has at least one recess adapted for receiving the mask frame.

According to a further embodiment, a method for processing a substrate is provided, the method including providing a substrate carrier; inserting the substrate to be processed into the substrate carrier; placing a mask frame over the substrate to be processed such that the mask frame forms an essentially planar surface with the adjacent surface of the substrate carrier; and processing the substrate.

### BRIEF DESCRIPTION OF THE DRAWINGS

So that the manner in which the above recited features of the present invention can be understood in detail, a more particular description of the invention, briefly summarized above, may be had by reference to embodiments. The accompanying drawings relate to embodiments of the invention and are described in the following:
- Figure 1: shows a schematic side sectional view of a holding device illustrated in an exploded view, according to a typical embodiment;
- Figure 2: illustrates the holding device shown in Fig. 1 in a condition when substrate processing may be carried out;
- Figure 3: is a substrate processing apparatus including a holding device where a mask is held by a mask frame, and a deposition source providing deposition material, according to another typical embodiment; and
- Figure 4: is a flowchart illustrating a method for processing a substrate using a mask device.

### DETAILED DESCRIPTION OF THE EMBODIMENTS

Reference will now be made in detail to the various embodiments of the invention, one or more examples of which are illustrated in the figures. Within the following description of the drawings, the same reference numbers refer to same components. Generally, only the differences with respect to individual embodiments are described. Each example is provided by way of explanation of the invention and is not meant as a limitation of the invention. For example, features illustrated or described as part of one embodiment can be used on or in conjunction with other embodiments to yield yet a further embodiment. It is intended that the present invention includes such modifications and variations.

Embodiments described herein refer inter alia to a holding device adapted for holding a mask and a substrate during processing of the substrate, e.g. while patterning the substrate surface. The substrate may be provided with a desired pattern using a deposition source providing deposition material, the deposition material being directed towards the substrate and the mask device.

In particular, the holding device includes a mask frame adapted for supporting the mask and a substrate carrier adapted for carrying the substrate. Furthermore, the substrate carrier has at least one recess adapted for receiving the mask frame. Shadow mask frames arranged on the substrate carrier may point in the direction where the deposition source is located. Such kind of shadow mask frames may cause shadowing effects during a deposition process, the shadowing effects resulting in a reduction of useable substrate area. On the other hand, an inserted mask frame avoids such loss of useable substrate area.

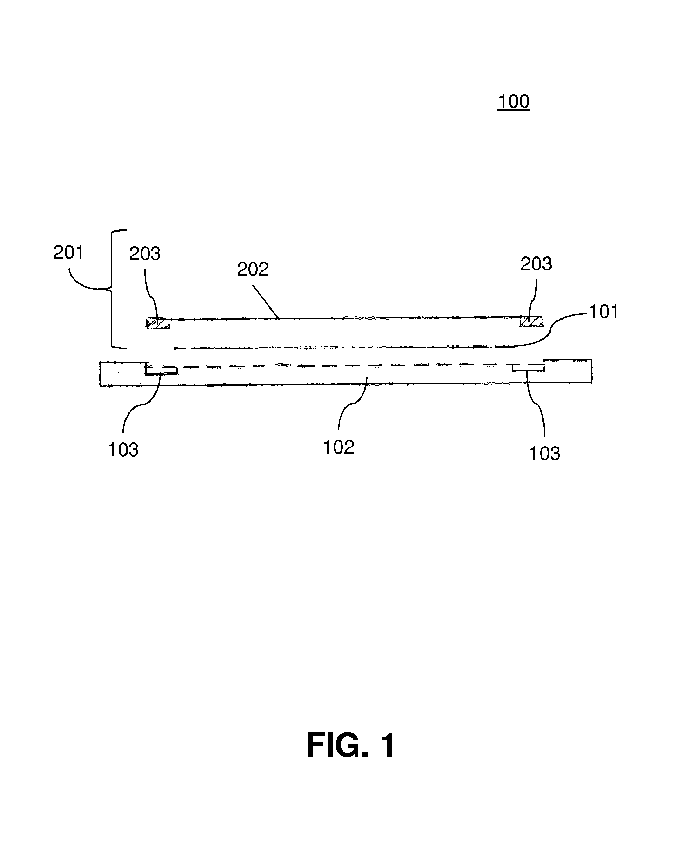

As shown in Fig. 1, a substrate carrier 102 is provided which has at least one recess 103. A substrate 101 to be processed is shown in an exploded view together with a mask device 201. The mask device 201 includes a mask foil 202 held by a mask frame 203. The mask frame 203 may have a cross-section of a rectangular shape as illustrated in Fig. 1. The mask frame 203 having the rectangular shape 203 is adapted to fit into the recess 103 of the substrate carrier 102.

The substrate 101 to be processed is held at a surface of the substrate carrier 102, the surface of the substrate carrier 102 being indicated by a broken line. The mask foil 202 is structured in a manner such that a desired pattern may be deposited onto the substrate surface to be processed by a deposition source (not shown in Fig. 1).

Thus, the mask foil 202 is adapted for patterning the substrate surface. The holding device 100 including the substrate carrier 102 and the mask device 201 may be arranged in a vacuum deposition apparatus for use in an in-line deposition process. A predetermined mask pattern is provided by the mask foil 202 such that the mask device 201 is acting as a shadow mask. Thus, a desired pattern may be transferred onto a substrate to be processed.

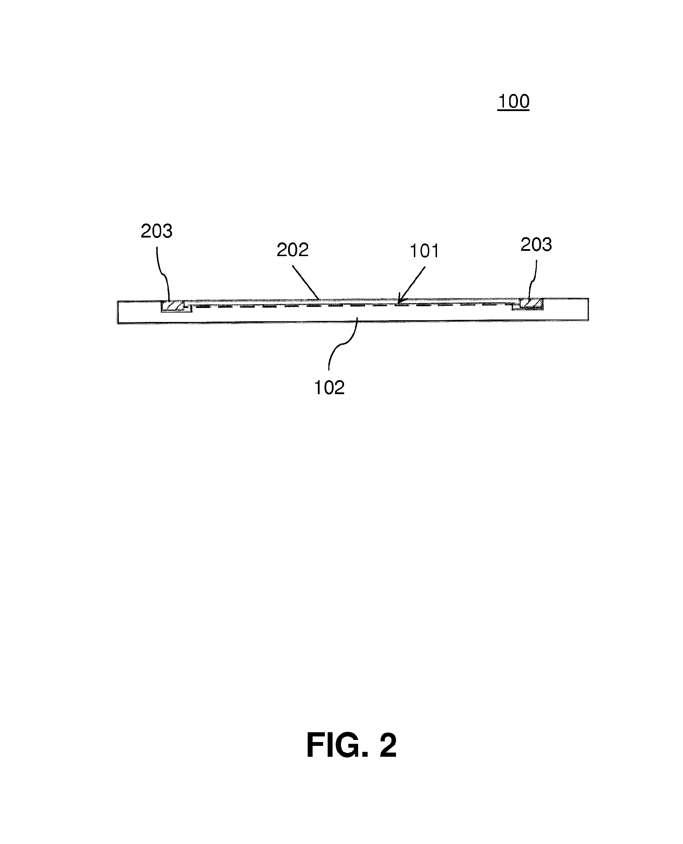

A layout pattern for large-scale integration may be provided, wherein a mask pattern pitch can be varied in a wide range. Such kind of masking may be used for the fabrication of OLEDs (organic light-emitting diodes). In order to obtain a large area covered by the mask device, i.e. by the mask device 201 acting as a shadow mask, a shadowing effect of the mask frame may be avoided, as will be described herein below with reference to Fig. 2.

It is noted here that the term "mask device" 201 relates to the combination of a mask foil and a mask frame, wherein the patterning of the substrate surface is provided by the part of the mask device201 providing the shadowing, i.e. by the mask foil or "mask".

The substrate carrier 102 of the holding device 100 may have a recess 103 which has a cross-sectional shape selected from a group consisting of a rectangular shape, a square shape, a concave shape and a triangular shape, and any combination thereof. Furthermore, the mask frame 203 of the mask device 201 may exhibit a cross-sectional shape which is selected from a group consisting of a rectangular shape, a square shape, a convex shape, a triangular shape and any combination thereof.

It is noted here that the mask frame 203 and the recess 103 of the substrate carrier 102 may be designed such that the mask frame 203 of the mask device 201 may fully fit into the recess 103 of the substrate carrier 102 such that the mask foil 202 together with the mask frame 203 of the mask device 201 is flush with an adjacent surface of the substrate carrier 102 once the mask device 201 is attached to the substrate carrier 102, as will be described herein below with respect to Fig. 2. The flush surface may be essentially planar. Thereby, minor protrusions may exist, e.g., at about less than 3% of the surface area of the flush surface, protrusions of 3 mm or below can exist. Further, manufacturing tolerances or the like may result in some deviation from a planar surface. Thus, the average surface height variation might be of 900 µm or below. Thereby, it has to be considered that manufacturing tolerances are influenced by the size of the mask, the carrier, and the like. For example, carriers and masks for smaller substrates can be manufactured with smaller tolerances as compared to large substrates.

The mask frame 203 may be formed of a material selected from the group consisting of thermal expansion stable material such as, e.g. Invar having a thermal expansion coefficient of about 1.2*10⁻⁶K⁻¹.

The mask foil 202 of the mask device, i.e. the "mask", may be formed of a material selected from the group consisting of a thermal expansion stable material e.g. Invar having a thermal expansion coefficient of about 1.2* 10⁻⁶K⁻¹ and any combination thereof. The substrate carrier 102 may be formed from a material selected from the group consisting of aluminium, stainless steel, e. g. AlMgSil, AlMg4,5Mn, and any combination thereof.

Fig. 2 is a side-sectional view illustrating a holding device 100 shown in Fig. 1 in a condition wherein the mask frame 203 together with the mask foil 202 and the substrate 101 are attached to the substrate carrier 102. The holding device 100 may provide a solid mechanical fixture of both the mask device 201 and the substrate 101.

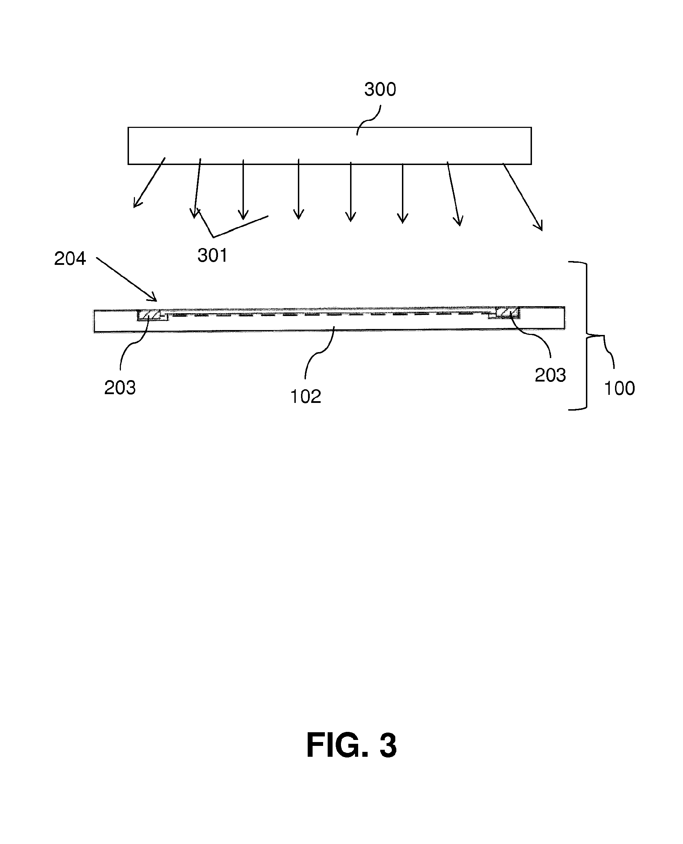

The mask device 201 including the mask foil 202 and the mask frame 203 adapted for holding the mask foil 202 may form a planar surface directed towards a deposition source described herein below with respect to Fig. 3. The smoothing feature is due to the fact that the mask frame 203 is received in the recess 103 provided in the substrate carrier 102, see Fig. 1. Minor protrusions may exist, e.g., at about less than 3% of the surface area of the flush surface, protrusions of 3 mm or below can exist. Thus, the average surface height variation might be of 900 µm or below. Thus, the term "planar" indicates that the shadowing effect due to a mechanical fixture of the mask, e.g. due to the mask frame 203 projecting from the surface of the mask, is avoided.

According to a typical embodiment which can be combined with other embodiments described herein, the recess 103 provided in the substrate carrier 102 and the mask frame 203 of the mask device 201 are adapted such that the surface of the mask frame 203 and the mask foil 202 is essentially flush with the adjacent surface of the substrate carrier 102. Thus, the recess 103 and the mask frame 102 are adapted such that the mask frame 203 forms an essentially flat surface with an adjacent surface of the substrate carrier 102.

The mask frame 203 is received in the recess 103 of the substrate carrier 102. A mechanical clamping may be provided for the mask frame 203 having attached thereon the mask foil 202, the mechanical clamping providing a solid mechanical fixture of the mask device 201 at the substrate carrier 102. Thus, the mask frame 203 having attached thereon the mask foil 202 may be placed over the substrate 101 to be processed. As a shadowing effect which may result from components projecting outwardly from the planar surface of the mask frame 203 and the adjacent surface of the substrate carrier 102, may be avoided, a usable substrate area can be increased.

Fig. 3 schematically shows a deposition apparatus including the holding device 100 and a deposition source 300 providing deposition material 301 for depositing a layer onto at least portions of the surface of the substrate 101. The holding device 100 provides a solid mechanical fixture of the substrate 101 and the mask device 201 at the substrate carrier 102, as described with reference to Fig. 2 herein above. The mask device 201 attached to the substrate carrier 102 is adapted such that the surface of the mask frame 203 is essentially flush with the adjacent surface of the substrate carrier 102, i.e. a flush surface 204 directed towards the deposition source 300 is provided.

As no shadowing effects can occur due to the planar, flush surface 204 oriented towards the deposition source 300, deposition material 301 is not shielded from being deposited onto the substrate surface to be processed. Thus an efficient utilization of deposition material may be provided and, due to this kind of masking the substrate 101 to be processed, production costs may be decreased. Furthermore, as the mask frame is received in the recess 103 of the substrate carrier 102, coating of the mask frame 203 by deposition material 301 is reduced and cleaning of the mask frame 203 is facilitated. As a consequence, an efficient reuse of the mask device 201 in subsequent processing steps may be provided.

The holding device 100 according to typical embodiments described herein may be employed in an in-line coating unit providing a vacuum deposition process. Gaseous deposition material 301 is mainly deposited directly onto the mask foil 202 and the surface of the substrate 101 to be processed, and a deposition of deposition material 301 onto components projecting from the planar surface provided by the mask device 201 and the substrate carrier 102 may be avoided. In addition to that, mask cleaning is facilitated, because the mask frame 203 may be completely received within the substrate carrier 102 such that only an upper surface of the mask foil 202 is exposed to deposition material 301 emitted from the deposition source 300. The mask frame 203 is arranged such that the mask frame 203 is inserted into the substrate carrier 102, thus preventing loss of usable substrate area through shadowing effects of the mask frame 203.

During a deposition process, only the upper surface of the mask foil 202 of the mask device 201 is coated by deposition material 301 provided by the deposition source 300. In addition to that, surface tension of the layers is reduced, because only a flat surface of the mask foil 202 may be coated by deposition material. Thus, a layer thickness may be increased until cleaning is required.

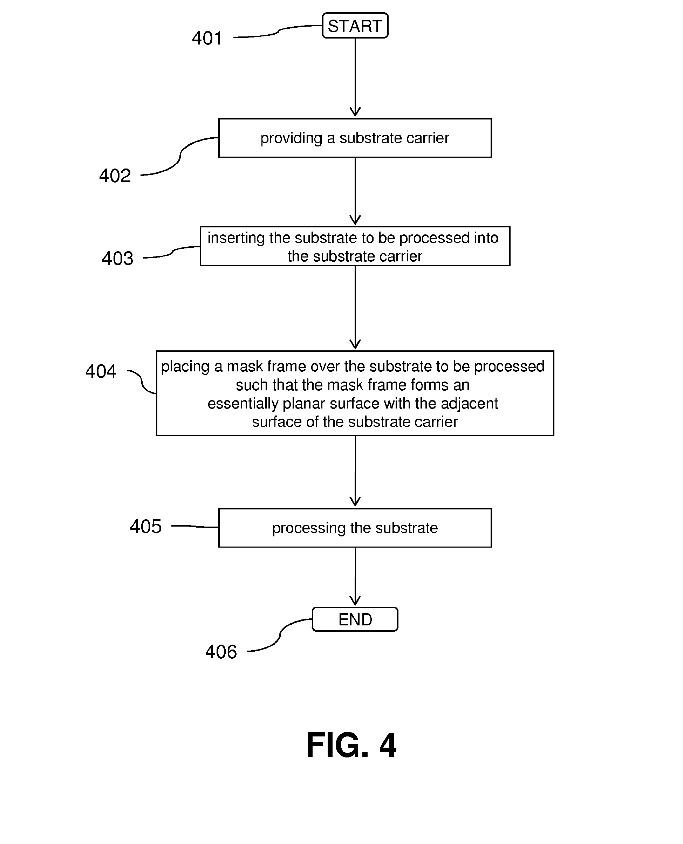

Fig. 4 is a flowchart illustrating a method for processing a substrate 101. The procedure starts at a block 401. A substrate carrier 102 is provided at a block 402. The substrate 101 to be processed is inserted into the substrate carrier 102 (block 403). Then, a mask frame 203 having attached thereon a mask foil 202 is placed over the substrate 101 to be processed such that the mask frame 203 together with the mask foil 202 forms an essentially planar surface with the adjacent surface of the substrate carrier 102.

After attaching the mask frame 203 together with the mask foil 202 and the substrate 101 to be processed to the substrate carrier 102, the substrate 101 may be processed at a block 405. The procedure is ended at a block 406. The mask foil 202 and the mask frame 203 holding the mask foil 202 may be reused in at least one further processing step.

In light of the above, a plurality of embodiments have been described. For example, according to one embodiment, a holding device adapted for holding a mask and a substrate during processing is provided, the holding device including a mask frame adapted for supporting the mask; and a substrate carrier adapted for carrying the substrate, wherein the substrate carrier has at least one recess adapted for receiving the mask frame. According to an optional modification thereof, the recess and the mask frame are adapted such that that the mask frame forms an essentially planar surface with the surface of the substrate carrier. According to yet further embodiments, which can be combined with any of the other embodiments and modifications above, the essentially planar surface is directed towards a deposition source adapted for substrate processing. According to yet further additional or alternative modifications the recess has a cross-sectional shape which is selected from the group consisting of a rectangular shape, a square shape, a concave shape, a triangular shape, and any combination thereof. Furthermore, the mask frame may have a cross-sectional shape which is selected from the group consisting of a rectangular shape, a square shape, a convex shape, a triangular shape, and any combination thereof. According to yet further embodiments, which can be combined with any of the other embodiments and modifications above, the essentially planar surface has an average surface height variation which amounts to approximately 900 µm or below. In addition to that, or alternatively, the mask frame is formed of a thermal expansion stable material such as Invar. According to yet further additional or alternative modifications the mask is formed of a thermal expansion stable material such as Invar. Moreover, the substrate carrier is formed from a material selected from the group consisting of aluminum, stainless steel, e.g. AlMgSil, AlMg4,5Mn, and any combination there are thereof. According to another embodiment, a method for processing a substrate is provided, the method including the steps of providing a substrate carrier; inserting the substrate to be processed into the substrate carrier; placing a mask frame over the substrate to be processed such that the mask frame forms an essentially planar surface with the adjacent surface of the substrate carrier; and processing the substrate. According to yet further embodiments, which can be combined with any of the other embodiments and modifications above, the essentially planar surface points towards a deposition source during substrate processing. According to yet further additional or alternative modifications the method includes reusing the mask foil and the mask frame holding the mask foil in at least one further substrate processing step. According to an optional modification thereof, the method may include clamping the mask frame having attached thereon the mask foil, at the substrate carrier.

While the foregoing is directed to embodiments of the invention, other and further embodiments of the invention may be devised without departing from the basic scope thereof, and the scope thereof is determined by the claims that follow.

## Claims

1. A holding device adapted for holding a mask and a substrate during processing, the holding device comprising:
a mask frame adapted for supporting the mask; and
a substrate carrier adapted for carrying the substrate,
wherein the substrate carrier has at least one recess adapted for receiving the mask frame.

2. The holding device in accordance with claim 1, wherein the recess and the mask frame are adapted such that that the mask frame forms an essentially planar surface with the surface of the substrate carrier.

3. The holding device in accordance with claim 1 or 2, wherein the essentially planar surface is directed towards a deposition source adapted for substrate processing.

4. The holding device in accordance with any one of the preceding claims, wherein the recess has a cross-sectional shape which is selected from the group consisting of a rectangular shape, a square shape, a concave shape, a triangular shape, and any combination thereof.

5. The holding device in accordance with any one of the preceding claims, wherein the mask frame has a cross-sectional shape which is selected from the group consisting of a rectangular shape, a square shape, a convex shape, a triangular shape, and any combination thereof.

6. The holding device in accordance with any one of the preceding claims, wherein the essentially planar surface has an average surface height variation which amounts to approximately 900 µm or below.

7. The holding device in accordance with any one of the preceding claims, wherein the mask frame is formed of a material selected from the group consisting of a thermal expansion stable material such as Invar.

8. The holding device in accordance with any one of the preceding claims, wherein the mask is formed of a material selected from the group consisting of a thermal expansion stable material such as Invar.

9. The holding device in accordance with any one of the preceding claims, wherein the substrate carrier is formed from a material selected from the group consisting of aluminum, stainless steel, AlMgSil, AlMg4,5Mn, and any combination there are thereof.

10. A method for processing a substrate, comprising:
providing a substrate carrier;
inserting the substrate to be processed into the substrate carrier;
placing a mask frame over the substrate to be processed such that the mask frame forms an essentially planar surface with the adjacent surface of the substrate carrier; and
processing the substrate.

11. The method in accordance with claim 10, wherein the essentially planar surface points towards a deposition source during substrate processing.

12. The method in accordance with claim 10 or 11, further comprising reusing the mask foil and the mask frame holding the mask foil in at least one further substrate processing step.

13. The method in accordance with any one of the claims 10 to 12, further comprising clamping the mask frame having attached thereon the mask foil, at the substrate carrier.
